# EUROPEAN PATENT SPECIFICATION

(11) **EP 0 935 015 B1**
(45) Date of publication and mention of the grant of the patent: **26.11.2008**
(21) Application number: 98122939.6
(22) Date of filing: 03.12.1998
(51) Int. Cl.: C30B 1/00, C30B 29/20, C30B 29/62

(54) **Method for producing whisker-forming alumina and alumina fibers and composite piston of alumina fibers**
Verfahren zur Herstellung von Whiskererzeugendem Aluminiumoxid und Aluminiumoxid-Fasern und Kolben aus Aluminiumoxidfasern-Verbundwerkstoff
Procédé pour la production de l'alumine susceptible de former des barbes et la production de fibres d'alumine ainsi qu'un piston composite comportant des fibres d'alumine

(30) Priority: 04.02.1998 JP 3659698; 09.09.1998 JP 27049498
(43) Date of publication of application: 11.08.1999
(73) Proprietor: Toyota Jidosha Kabushiki Kaisha, Toyota-shi, Aichi-ken, 471-8571 (JP)
(72) Inventor: Shintani, Yoshitomo, Toyota-shi, Aichi-ken 471-8571 (JP); Okochi, Yukio, Toyota-shi, Aichi-ken 471-8571 (JP)
(74) Representative: TBK-Patent

(56) References cited:
- EP-A- 0 856 497
- GB-A- 998 166
- US-A- 4 643 078
- PATENT ABSTRACTS OF JAPAN vol. 096, no. 004, 30 April 1996 & JP 07 330500 A (NICHIAS CORP), 19 December 1995
- PATENT ABSTRACTS OF JAPAN vol. 096, no. 004, 30 April 1996 & JP 07 330499 A (NICHIAS CORP), 19 December 1995
- PATENT ABSTRACTS OF JAPAN vol. 017, no. 704 (C-1146), 22 December 1993 & JP 05 238900 A (MITSUI MINING CO LTD), 17 September 1993

## Description

### BACKGROUND OF THE INVENTION

### 1. Field of the Invention

The present invention relates to a method for forming whiskers on the surface of alumina and, in particular, to a method for producing whisker-forming alumina which enables the production of the whiskers-forming alumina efficiently and at a high volume-fraction by dry molding, and alumina fibers and a composite piston in which the alumina fibers are composed with a matrix material.

### 2. Description of the Prior Art

Usually, whiskers are complete acicular crystals, and can be plastically worked in a relatively small volume-fraction region as a short fiber. In particular, the whiskers can be molded by extrusion or rolling, and they further maintain a high temperature strength near the melting point of the matrix metal or alloy. Moreover, since the whiskers have a function of protecting from damage such as friction, they are expected to expand their application as parts of internal combustion engines of automobiles, etc. For example, although Al base composite materials, and the like, are used in the ring carrier portions of piston rings in engine pistons where the sliding conditions are severe, application of the whiskers to the ring carrier portions can be considered for improving the wear resistance thereof. On the other hand, as regards aluminum borate whiskers, for example, Japanese Unexamined Patent Publication (Kokai) No. 7-330500 discloses that the aluminum borate whiskers are formed by heating aluminum oxide, boron oxide and iron oxide in the air. Moreover, Japanese Unexamined Patent Publication (Kokai) No. 7-330499 discloses a method for preparing granular aggregates of aluminum borate whiskers by heating in air cohesive grains of a mixture which comprises aluminum oxide or an aluminum compound to be converted into aluminum oxide when it is heated, and boron oxide or a boron compound to be converted into boron oxide when it is heated, at temperatures for forming aluminum borate whiskers.

For such conventional processes for producing a compact as a molded article of aluminum borate whiskers, the compact as molded article is effective when used as strengthening members. However, when it is used as a wear-resistant member, they cause a problem regarding wear resistance. When a hybrid of alumina fibers and whiskers can be synthesized, the wear resistance and strength of a MMC (metal matrix composite) and a FRP (fiber-reinforced plastic) can be improved by utilizing the synergistic effects of both substances.

Accordingly, it has been desired to develop a method capable of producing whisker-forming alumina having various forms (short fibers, long fibers and granules) and excellent in strength and wear resistance, by a relatively simple process at low cost.

EP-A-0 856 497 discloses a process for producing a porous inorganic material which consists solely of needle like crystals of aluminium borate.

Abstract of JP 07 330499 discloses a method for producing granular aggregates of aluminium borate whiskers.

GB 998 166 A discloses a method for producing a mass of refractory whiskers which are formed in a furnace by deposition from the vapour phase.

US-A-4 643 078 discloses a composite piston, reinforced with alumina fibers.

JP-A-07 330500 discloses a method of producing whisker-forming alumina comprising adding of iron before heating.

JP-A-05 238900 discloses a method for forming an alumina whisker consisting of filling a crucible with an aluminium borate whisker, and heat tresting it.

### SUMMARY OF THE INVENTION

An object of the present invention is to provide a method which improves the production efficiency at the time of molding a hybrid, to change the production from conventional wet molding to simple dry molding, and to provide a method for producing whisker-forming alumina by uniformly mixing alumina short fibers with boron oxide or a powder to be converted into boron oxide when it is heated and heating the mixture.

Another object of the present invention is to provide a molding method in which breakage, which often occurs during dry pressing, is prevented, and to provide a method for producing whisker-forming alumina in a high volume-fraction.

Another object of the present invention is to provide a method for producing whisker-forming alumina which can produce synergistic effects of the whiskers and the alumina fibers to further improve the strength and wear resistance of a MMC or FRP when used therefor. A particular object of the present invention is to apply the alumina fibers of the invention as a composite material to the ring carrier portion which has a piston-ring groove of an engine piston and on which severe sliding conditions are imposed, so that the piston is made lightweight and its adhesion resistance is further improved.

Furthermore, in order to inhibit as much as possible the formation of H₂O generated during the decomposition of boric acid in the present invention, preheating boric acid has been adopted. As a result, the present invention provides a method for producing whisker-forming alumina which method is capable of preventing gap formation within the compact.

The gist of the present invention which can achieve the object of the above will be described as follows.
(1) A method for producing whisker-forming alumina which forms whiskers on the surface of alumina is characterized by the steps of uniformly mixing aluminum oxide fibers with boron oxide or a powder to be converted into boron oxide when it is heated, and subsequently heating the resultant mixture as defined in claim 1.
(2) A method for producing whisker-forming alumina which forms whiskers on the surface of alumina is characterized by the steps of uniformly mixing aluminum oxide fibers with boron oxide or a powder to be converted into boron oxide when it is heated, molding by compressing the resultant mixture to form a compact, and subsequently heating the compact as defined in claims 1 and 2
(3) A method for producing whisker-forming alumina which forms whiskers on the surface of alumina is characterized by the steps of molding by compressing aluminum oxide fibers to form a compact, providing boron oxide or a powder to be converted into boron oxide when it is heated for surrounding the surface of the compact, and subsequently heating the resultant compact as defined in claim 3.
(4) A method for producing whisker-forming alumina according to item (1), (2) or (3), wherein a proportion of aluminum component to boron component is 9:2.5 to 1:1 in terms of molar ratio.
(5) The method for producing whiskers-forming alumina according to item (2) or (3), wherein boron oxide is preheated to a temperature of at least 180°C at the time of mixing or providing it.
(6) Alumina fibers are characterized in that whiskers are formed dendritically on the surface of alumina.
(7) A composite piston is characterized in that the alumina fibers according to item (6) are composed with a matrix material at least in a wear resistant portion of a ring carrier.

### BRIEF DESCRIPTION OF THE DRAWINGS

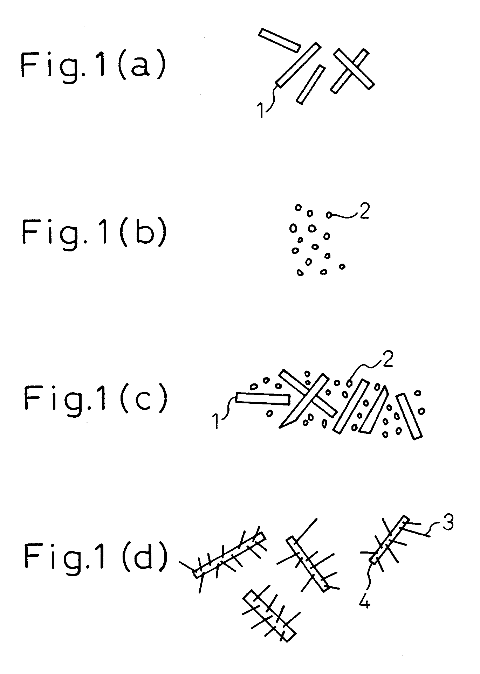

Fig. 1 (a) to Fig. 1 (d) are views showing the outline of the production process according to claim 1 of the present invention. Fig. 1 (a) shows a view of alumina short fibers, Fig. 1 (b) shows a view of boric acid, Fig. 1 (c) shows a view of step of a mixer and Fig. 1 (d) shows a view of whiskers grown.

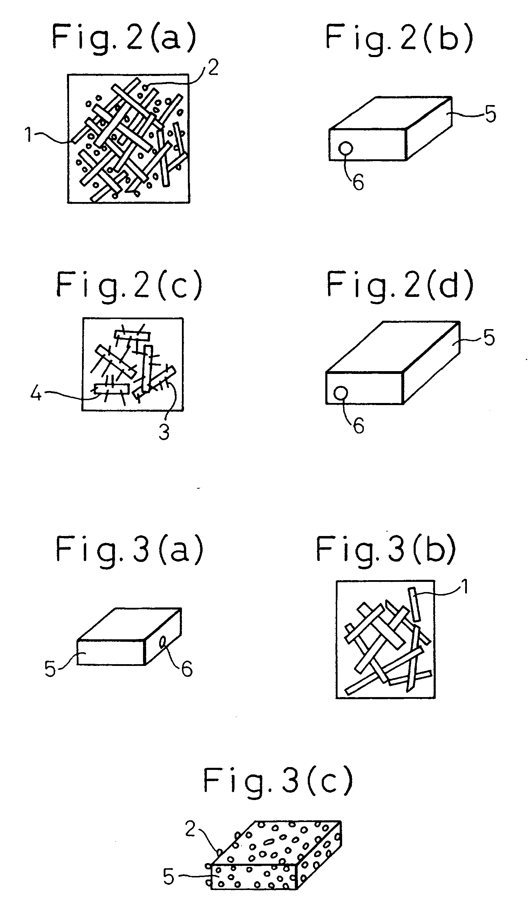

Fig. 2 (a) to Fig. 2 (d) are views showing the outline of the production process according to claim 2 of the present invention. Fig. 2 (a) shows an enlarged view of a molded particle portion 6 in Fig. 2 (b), Fig. 2 (b) shows a view of a molded particle, Fig. 2 (c) shows an enlarged view of a molded particle portion 6 in Fig. 2 (d) and Fig. 2 (d) shows a view of a molded particle.
Fig. 3 (a) to Fig. 3 (c) are views showing the outline of the production process according to claim 3 of the present invention. Fig. 3 (a) shows a view of a molded particle, Fig. 3 (b) shows a view of an enlarged view of a mold particle portion 6 in Fig. 3 (a), and Fig. 3 (c) shows a view of boric acid surrounding a molded particle.

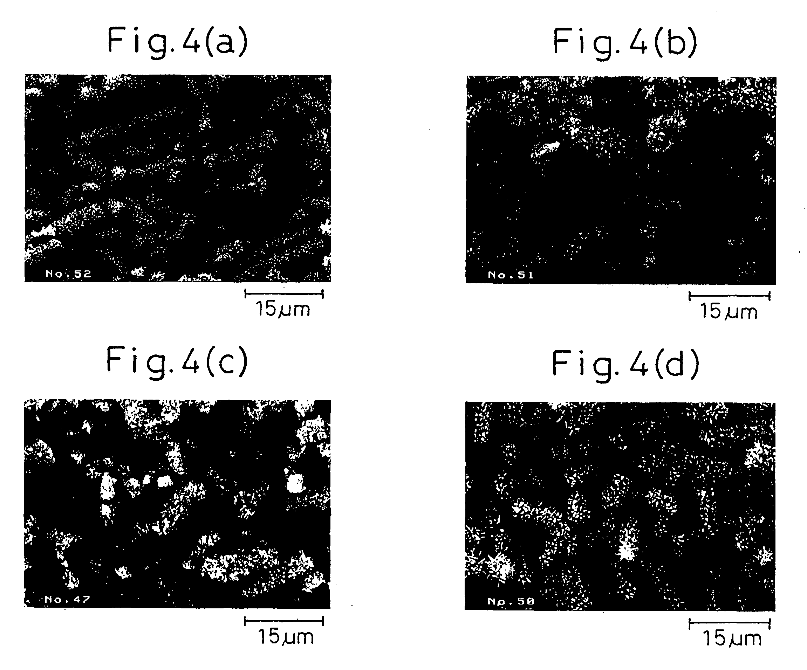

Fig. 4 (a) to Fig. 4 (d) are scanning electron microscopic photographs of dendritic whisker-forming alumina wherein Fig. 4 (a) is a photograph in Example 2, Fig. 4 (b) is a photograph in Example 5, Fig. 4 (c) is a photograph of the alumina having been prepared with a mixing proportion of aluminum hydroxide:boric acid:alumina short fibers = 59:23:18 (%), and Fig. 4 (d) is a photograph of the alumina having been prepared with a mixing proportion of aluminum hydroxide:boric acid:alumina short fibers = 48:19:33 (%).

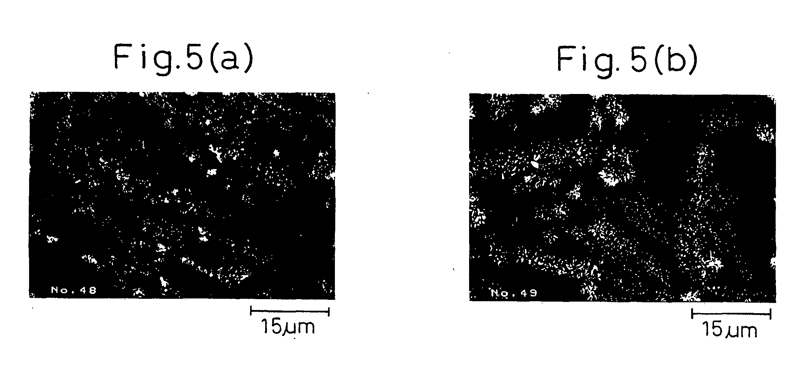

Figs. 5 (a) and 5 (b) are scanning electron microscopic photographs of dendritic whisker-forming alumina wherein Fig. 5 (a) is a photograph of the alumina having been prepared with a mixing proportion of aluminum hydroxide:boric acid:alumina short fibers:nickel oxide = 57:23:17:3 (%), and Fig. 5 (b) is a photograph of the alumina having been prepared with a mixing proportion of aluminum hydroxide:boric acid:alumina short fibers = 53:21:26 (%).

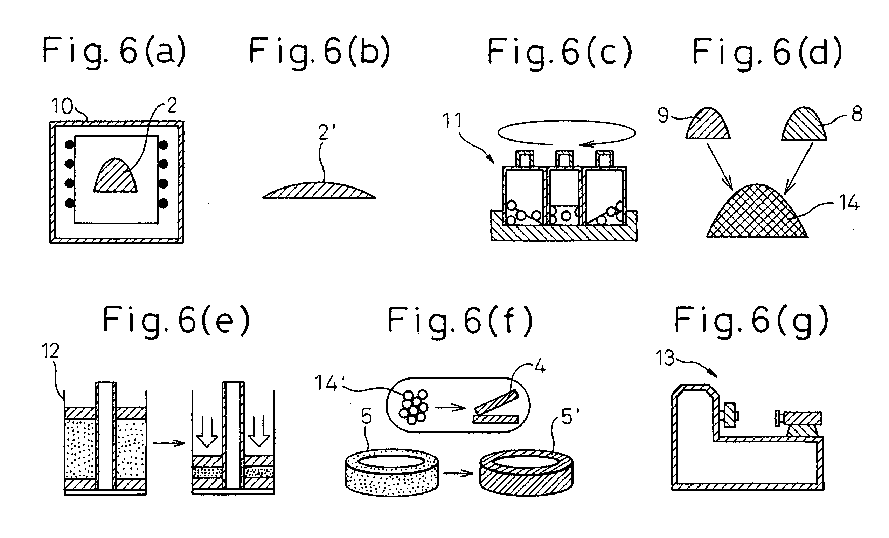

Fig. 6 (a) to Fig. 6 (g) are views showing the outline of the production process according to claim 4 of the present invention. Fig. 6 (a) is a view showing a heating furnace: Fig. 6 (b) is a view showing a preheated boric acid Fig. 6 (c) is a view showing a planetary ball mill. Fig. 6 (d) is a view showing raw materials. Fig. 6 (e) is a view showing a mold. Fig. 6 (f) is a view showing a compact. Fig. 6 (g) is a view showing a working apparatus.

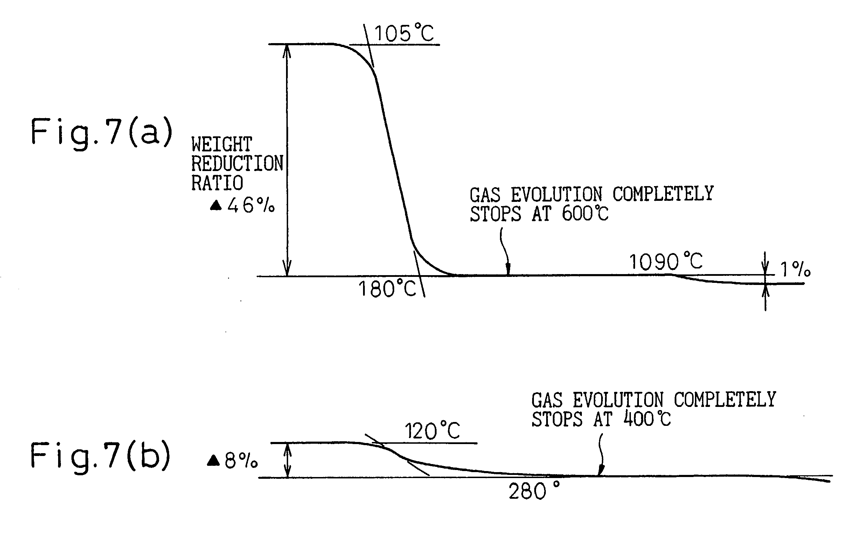

Figs. 7 (a) and 7 (b) are graphs showing the thermal decomposition of boric acid according to the present invention, wherein Fig. 7 (a) relates to boric acid, and Fig. 7 (b) relates to boric acid having been heated in advance.

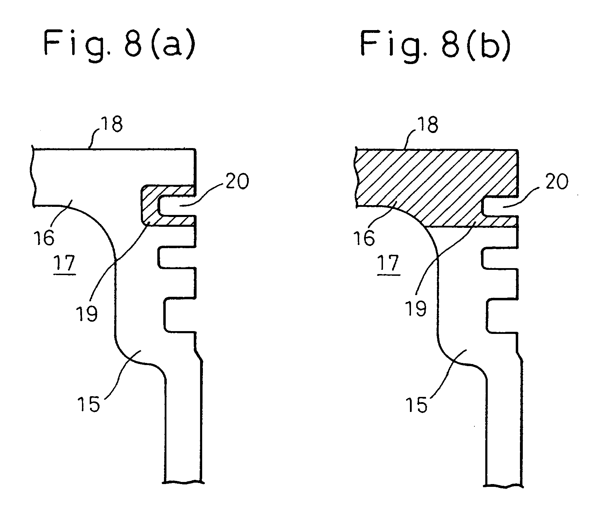

Figs. 8 (a) and 8 (b) are views associated with the application of the present invention to pistons in Example 8, wherein Fig. 8 (a) is an example of applying the invention to a top ring groove, and Fig. 8 (b) is an example of applying the invention to an entire top portion.

### DETAILED DESCRIPTION OF THE PREFERRED EMBODIMENT

In the present invention, the step of mixing raw material powders and/or the step of molding is conducted not by wet pressing in a molten liquid state but completely by dry pressing, and, in the heating step, the dry pressed article is heated to a synthetic temperature to directly produce a compact in which whiskers are formed on the surface of alumina. In the conventional production of the aggregates of aluminum borate whiskers, acicular short fiber whiskers are cohered to give the aggregates, or they are merely arranged in a three-dimensional and random manner to give a whisker molded article. However, as mentioned above, the whisker molded article can be simply obtained in a good yield by only the process of heating to a synthesizing temperature in air.

The features of the present invention can be explained in the following manner.

A first feature of the present invention is as follows: the alumina raw material is fibrous aluminum oxide, or it can further contain a substance such as aluminum hydroxide or aluminum sulfate to be converted into aluminum oxide when it is heated; the boron source is boron oxide or a boron compound to be converted into boron oxide when it is heated, for example, H₃BO₃, H₂B₄O₇, HBO₂, or the like. Moreover, the addition amount is in a proportion of the aluminum component to the boron component of 9:2.5 to 1:1 in terms of molar ratio.

A second feature of the present invention is to heat the mixture or molded article in air or in an Ar atmosphere. As described later, since the shape of the whiskers is greatly influenced by the addition ratio as shown in examples of the present invention, it is considered that the whiskers can be synthesized and grown simultaneously during heating. That is, in the growth of whisker crystals is considered that initial crystals are produced by reacting the substrate alumina with boric acid, and then they grow to large crystals. In the molding method, a method of continuous feeding or a batch feeding wherein a necessary amount of the substance is kept in a closed vessel, or a mass transfer method by utilizing a temperature gradient may be applied to the present invention. This does not influence the effects of the invention at all.

Moreover, since the chemical and the physical properties of the whiskers in the present invention can simultaneously be controlled by a solid phase reaction as a fundamentals, whiskers having fewer defects, a high strength which approximates a theoretical value, a high wear resistance and a high adhesion resistance are obtained.

The heating temperature is in the temperature region of at least 1000°C where a solid phase reaction is promoted, and thus it is important to promote the diffusion of each of the elements in the solid phase decomposition and synthesis. Further, the whiskers of the present invention are used as a MMC (metal matrix composite) of various materials to improve the reinforcement and functional properties thereof.

Since a parameter as the product of the maximum tensile strength of the whiskers and the volume fraction is a strengthening factor for effects of the composing MMC mentioned above, improvement in the volume-fraction as well as the maximum tensile strength becomes particularly important. A molded article having a volume fraction of at least 40% can be obtained by the present invention.

The outline of the first aspect of the present invention is shown in Figs. 1 (a) to 1 (d). Fig. 1 (a) and Fig. 1 (b) show alumina short fibers 1 and boric acid 2 as raw materials, respectively. The raw materials are homogeneously stirred and mixed by a mixer, as shown in Fig. 1 (c). The mixture is held at temperatures of at least 1000°C by the subsequent heating step until whiskers grow sufficiently, as shown in Fig. 1 (d). As a result, a hybrid material with whiskers formed on the surface of alumina can be produced. Moreover, in the present invention, a molded article of whiskers having a high V_{f} (high volume fraction) can be obtained without damaging the whiskers by the process for producing whiskers from powder. Further, in the present invention, the molded article can be produced without using any of the binders; therefore, whiskers having excellent heat conductivity can be obtained.

In the second aspect of the present invention, a molded article having a high density can be obtained compared with a molded article obtained by molding a hybrid material thus formed in the first aspect of the invention. Although the second aspect of the invention is the same as the first one up to the mixing step, a molded article is formed by the step of molding the mixture in the second aspect of the invention.

The second aspect of the invention is shown in Figs. 2 (a) to 2 (d). As shown in enlarged views of Figs. 2 (a) and 2 (c), the internal structure of a compression molded article 5 is homogeneously mixed, and has a high density. The compression molded article attains a high volume fraction even after forming a hybrid material covered with whiskers formed on the surface of alumina by heat treatment.

Furthermore, in the third aspect of the present invention, as shown in Figs. 3 (a) to 3 (c), first, aluminum oxide fibers is compression molded to give a molded article 5 in Fig. 3 (a), and the molded article 5 is surrounded with boric acid 2 in Fig. 3 (c), followed by heat treating the molded article 5. As a result, formation of inner pores 7, which is likely to take place subsequently to the reaction of boron in the second aspect of the invention, can be extremely suppressed. A molded article having a high density can thus be obtained.

Still furthermore, in the fourth aspect of the present invention, because coarse pores may formed within the molded article in the synthetic stage and in order to prevent the formation of the pores, the H component in the boric acid is removed in advance to suppress formation of the decomposition gas (H₂O) of boric acid which causes pore formation. As regards the reaction, the following are clarified. X-ray diffraction has confirmed that when boric acid is heated, the following reactions take place:

H₃BO₃ (boric acid) → HBO₂ (metaboride) + H₂O ↑ (300°C)

H₃BO₃ (sassolite) → boric acid glass (amorphous) + H₂O ↑ (1200°C)

The boric acid glass is amorphous, transparent and glassy. The boric acid glass was ground for 2 hours by a planetary ball mill. Fig. 7 (b) shows the results of subjecting the powder to thermogravimetric analysis. It is understood from Fig. 7 (b) that a decrease in the weight starts from 120°C and the weight is substantially stabilized at 280°C, and that evolution of gas completely stops at 400°C to show a weight reduction ratio of 8%. On the other hand, Fig. 7 (a) shows the results of subjecting boric acid to thermogravimetric analysis. It is understood from Fig. 7 (a) that a decrease in the weight starts from 105°C and the weight is substantially stabilized at 180°C, that evolution of gas completely stops at 600°C, and that a weight decrease is slightly observed at 1090°C and the weight reduction ratio is 46%. That is, preheating boric acid can decrease the generation amount of H₂O to 1/6 of that of H₂O for boric acid without preheating. Consequently, it is thought that this is the reason that formation of pores within the molded article becomes difficult.

Next, Fig. 6 shows the outline of the production process including a step of heating boric acid in advance.

Firstly, as shown in Fig. 6 (a), boric acid is heated within a heating furnace 10 at about 1200°C to remove H₂O thus formed. A heating temperature of at least 180°C is satisfactory. It is seen from the weight reduction curve that the amount of removal is stabilized at 600°C. The heating temperature is, therefore, preferably at least 600°C. When the heating is conducted at temperatures lower than 600°C, the heating time must be extended.

Boric acid 2' (Fig. 6 (b)) thus heated is ground for about 2 hours with a planetary ball mill 11 (Fig. 6 (c)). Powder 9 thus obtained is mixed with aluminum oxide (alumina short fibers) 8 to give mixed raw materials 14 (Fig. 6 (d)). The mixed raw materials are dry molded (Fig. 6 (e)), and the molded article is heated again at about 1200°C to form whiskers (Fig. 6 (f)). The thus obtained molded article of the short fibers of the whisker-forming alumina is machined to obtain any one of the various parts (Fig. 6 (g)). In addition, the reference numeral 14' in the figure designates raw materials subsequent to molding. The reference numerals 4 and 5' designate short fibers of the whisker-forming alumina and a molded article subsequent to heating, respectively.

Next, the relationship between formation of whiskers and a mixing proportion of the raw materials will be explained.

Raw materials for synthesizing whiskers of the present invention were mixed in an optimum proportion, dry molded, and fired. Figs. 4 (a) to 4 (d) and Figs. 5 (a) to 5 (b) are scanning electron microscopic photographs of such fired molded articles. The figures show aggregates of dendritic whiskers on the surface of alumina. It is understood therefrom that the aggregates have a uniform magnitude and the same orientation. In addition, Figs. 4 (a) and 4 (b) were obtained in examples described later. Fig. 4 (c) is a photograph of the aggregates having been prepared with a mixing proportion of aluminum hydroxide:boric acid:alumina short fibers = 59:23:18 (%), and Fig. 4 (d) is a photograph of the aggregates having been prepared with a mixing proportion of aluminum hydroxide:boric acid:alumina short fibers = 48:19:33 (%). Fig. 5 (a) is a photograph of the aggregates having been prepared with a mixing proportion of aluminum hydroxide:boric acid:alumina short fibers:nickel oxide = 57:23:17:3 (%), and Fig. 5 (b) is a photograph of the aggregates having been prepared with a mixing proportion of aluminum hydroxide:boric acid:alumina short fibers = 53:21:26 (%). In addition, the alumina short fibers have a diameter of about 4 µm and a length of 10 to 200 µm. The whiskers thus formed have a diameter of about 0.5 µm, and a length of about 1 to 3 µm.

As explained above, whisker-forming alumina, which has never been produced before, can be obtained in the present invention. When a MMC is formed therefrom, a MMC excellent in strength and adhesion resistance in addition to the conventional high strength can be obtained.

Next, the alumina fibers and the application thereof in the present invention will be explained in relation to the eighth and the ninth aspect of the present invention.

For engine pistons, ring carrier portions having piston ring grooves are the members on which the alumina fibers of the invention best achieves the effects of improving wear properties and cohesion resistance.

That is, for a part which is required to be used under severe sliding conditions, for example, for an Al system matrix, the Al component is transferred to the counterpart. In order to prevent the phenomenon and improve the strength of the matrix, the dispersion strengthening effects of a composite material are further improved. Since dendritic whiskers are aggregated on the surface of the alumina in a high volume fraction in the alumina fibers of the invention, the alumina fibers are optimum for improving the cohesion resistance and wear resistance of a sliding member such as a piston by the high density dispersion strengthening effects.

The present invention will be explained below in detail with reference to examples.

### EXAMPLES

### Example 1

In the present example, 11 g of boric acid was mixed with 14 g of alumina short fibers (mixing proportion of 44:56 in terms of wt.% ratio). The resultant powder mixture was placed in an alumina crucible, and heated at 1200°C for 3 hours.

When the heating was finished, the reaction products were cooled to give dendritic whisker-forming alumina short fibers.

### Example 2

In the present example, a powder mixture of the same formulation as in Example 1 was charged into a mold 30 mm in diameter, and compressed.

The molded article was heated at 1200°C for 3 hours.

When the heating was finished, the reaction products were cooled to give dendritic whisker-forming alumina short fibers as shown in a scanning electron microscopic photograph (Fig. 4 (a)) of whiskers in the molded article. The volume fraction of the molded article was 60%.

### Example 3

In the present example, 14 g of alumina short fibers were charged into a mold 30 mm in diameter, and compressed.

The resultant molded article was then coated with 20 g of boric acid, and heated at 1200°C for 5 hours.

When the heating was finished, remaining unreacted boric acid was removed. In the present example, a molded article containing no pores and composed of dendritic whisker-forming alumina short fibers was obtained.

### Example 4

The procedure of Example 2 was repeated except that heating was conducted in an Ar atmosphere in place of air atmosphere to give dendritic whisker-forming alumina short fibers which were similar to those in Example 2.

### Example 5

In the present example, a powder mixture of 9 g of aluminum hydroxide, 7 g of boric acid and 9 g of alumina short fibers (mixing proportion of 36:28:36 in terms of wt.% ratio) was charged into a mold 30 mm in diameter, and compressed.

The molded article was then heated at 1000°C for 5 hours.

When the heating was finished, the reaction products were cooled to give dendritic whisker-forming alumina short fibers as shown in a scanning electron microscopic photograph (Fig. 4 (b)) of whiskers in the molded article.

### Example 6

The procedure of Example 1 was repeated except that alumina long fibers and alumina granules were used in place of alumina short fibers.

The reaction products were cooled to give dendritic whisker-forming alumina short fibers and dendritic whisker-forming alumina granules.

### Example 7

In the present example, the effects of preheating boric acid on suppressing the pores were investigated. A mixture of 7.5 g of alumina short fibers and 2.5 g of boron oxide powder, obtained by preheating boric acid at 1200°C and grinding was molded at a bearing pressure of 12 ton/cm². The resultant molded article was synthesized at 1200°C for 3 hours. The resultant molded article contained no coarse pores in the interior, and dendritic whiskers were formed on the surface portions of the alumina short fibers. The volume fraction of the molded article was 60%.

### Comparative Example

Powder obtained by mixing 7.5 g of alumina short fibers and 2.5 g of boric acid was molded at a surface pressure of 12 ton/cm². The resultant molded article was synthesized at 1200°C for 3 hours. The molded article showed coarse pores in the interior.

### Example 8

In the present example, the alumina fibers of the invention were applied to a piston used for a diesel engine. Fig. 8 (a) shows a top ring groove-forming region where the alumina fibers were applied. Fig. 8 (b) shows an upper portion of a piston head side into which the alumina fibers of the invention were entirely inserted as an internal insert method. In Fig. 8 (a), a piston 16 composed of an Al base material comprised a piston head 18 and a piston body 15 made of an Al alloy material and having a cavity 17. A plurality of ring grooves 20 were provided by machining on the side of the piston head 18 of the piston body, and a strengthened portion 19 was formed in the top ring groove. In Fig. 8 (b), a strengthened portion was formed as the entire top portion by the internal insert method. The strengthened portion 19 was formed by forming a composite of the alumina fibers of the invention and the Al alloy. Alumina fibers having a diameter of about 4 µm and a length of 10 to 200 µm were used as the strengthening material, and the volume fraction of the strengthening material was from 20 to 70%. In addition, the top ring groove was formed by machining, and the machinability was good. When a top ring was mounted on the top ring groove, the sliding properties were improved and the cohesion resistance was good at the time of driving a diesel engine.

According to the present invention, a material in which whiskers are formed on the surface of alumina can be efficiently obtained, and the material can be stably obtained when dry pressing is applied. Moreover, whisker aggregates in a high volume fraction are obtained by a combination of the mixing step and the molding step. Furthermore, formation of pores after the reaction of boric acid can be prevented by surrounding the molded article with boric acid, and formation of pores can be prevented, and the properties of a MMC, for example, a piston or the like to be used under severe sliding conditions can be improved by preheating the boric acid to prevent the formation of pores.

The process of the present invention is characterized in the steps of uniformly mixing fibrous aluminum oxide and a powder which is boron oxide or which is to be converted into boron oxide by heating, and heating the mixture at 1000°C to 1200°C for 3 to 5 hours. Furthermore, the process comprises the steps of compressing powdery or fibrous aluminum oxide to mold the aluminum oxide, providing on the molded article surface a powder which is boron oxide or which is to be converted into boron oxide by heating, and heating the molded article. The present invention further provides alumina fibers which are produced by heating boron oxide in advance, and a piston in which alumina fibers are composed.

## Claims

1. A method for producing whisker-containing material comprising the steps of uniformly mixing aluminum oxide fibers with boron oxide or a powder to be converted into boron oxide when it is heated, and subsequently heating the resultant mixture at 1000 to 1200°C for 3 to 5 hours, thus forming dendritically whiskers on the surface of said fibers.

2. A method according to claim 1, **characterized by** molding by compressing the resultant mixture to form a compact, and subsequently heating the compact.

3. A method for producing whisker-containing material comprising the steps of molding by compressing aluminum oxide fibers to form a compact, providing boron oxide or a powder to be converted into boron oxide when it is heated for surrounding the surface of the compact at 1000 to 1200°C for 3 to 5 hours, and subsequently heating the resultant compact, thus forming dendritically whiskers on the surface of said fibers.

4. A method for producing whisker-forming alumina according to claim 1, 2 or 3, wherein a proportion of aluminum component to boron component is 9:2.5 to 1:1 in terms of molar ratio.

5. A method for producing whisker-forming alumina according to claim 2 or 3, wherein the volume fraction of whiskers in the compact is 60 to 70%.

6. The method for producing whisker-forming alumina according to claim 2 or 3, wherein boron oxide is preheated to a temperature of at least 180°C at the time of mixing or providing it.

7. Alumina fibers having whiskers being formed dendritically on the surface of said fibers.

8. A composite piston comprising alumina fibers according to claim 7, said fibers being composed with a matrix material at least in a wear resistant portion of a ring carrier.

## Patentansprüche

1. Verfahren zur Herstellung Whisker-enthaltenden Materials, umfassend die Schritte von gleichmäßigem Mischen von Aluminiumoxidfasern mit Boroxid oder einem Pulver, das in Boroxid umgewandelt wird, wenn es erwärmt wird, und anschließendem Erwärmen der resultierenden Mischung bei 1000 bis 1200°C für 3 bis 5 Stunden, somit dendritische Whisker auf der Oberfläche der Fasern bildend.

2. Verfahren nach Anspruch 1, **gekennzeichnet durch** Formen **durch** Verdichten der resultierenden Mischung, um einen Presskörper zu bilden, und anschließendes Erwärmen des Presskörpers.

3. Verfahren zur Herstellung Whisker-enthaltenden Materials, umfassend die Schritte von Formen durch Verdichten von Aluminiumoxidfasern, um einen Presskörper zu bilden, Bereitstellen von Boroxid oder einem Pulver, das in Boroxid umgewandelt wird, wenn es erwärmt wird, zum Umschließen der Oberfläche des Presskörpers bei 1000 bis 1200°C für 3 bis 5 Stunden, und anschließendem Erwärmen des resultierenden Presskörpers, somit dentritische Whisker auf der Oberfläche der Fasern bildend.

4. Verfahren zur Herstellung Whisker-bildenden Aluminiumoxids nach Anspruch 1, 2 oder 3, wobei ein Verhältnis bezüglich Molverhältnis vom Aluminiumbestandteil zum Borbestandteil bei 9 : 2.5 bis 1 : 1 liegt.

5. Verfahren zur Herstellung Whisker-bildenden Aluminiumoxids nach Anspruch 2 oder 3, wobei der Volumenanteil an Whisker in dem Presskörper bei 60 bis 70% liegt.

6. Verfahren zur Herstellung Whisker-bildenden Aluminiumoxids nach Anspruch 2 oder 3, wobei Boroxid zum Zeitpunkt des Mischens oder Bereitstellen dafür zu einer Temperatur von wenigstens 180°C vorgewärmt wird.

7. Aluminiumoxidfasern mit Whisker, die dendritisch auf der Oberfläche der Fasern gebildet sind.

8. Kompositkolben, umfassend Aluminiumoxidfasern nach Anspruch 7, wobei die Fasern wenigstens in einem verschleißbeständigen Abschnitt eines Tragrings mit einem Matrixmaterial verbunden sind.

## Revendications

1. Procédé pour produire un matériau contenant des trichites comprenant les étapes consistant à mélanger uniformément des fibres d'oxyde d'aluminium avec de l'oxyde de bore ou une poudre à convertir en oxyde de bore par chauffage, et à chauffer ultérieurement le mélange résultant à 1000 à 1200°C pendant 3 à 5 heures, formant ainsi de manière dendritique des trichites sur la surface desdites fibres.

2. Procédé selon la revendication 1, **caractérisé par** le fait de mouler par compression le mélange résultant pour former un élément compact, et chauffer ultérieurement l'élément compact.

3. Procédé pour produire un matériau contenant des trichites comprenant les étapes consistant à mouler par compression les fibres d'oxyde d'aluminium afin de former un élément compact, fournir de l'oxyde de bore ou une poudre à convertir en oxyde de bore par chauffage pour entourer la surface de l'élément compact à 1000 à 1200 °C pendant 3 à 5 heures, et chauffer ultérieurement l'élément compact résultant, formant ainsi de manière dendritique des trichites sur la surface desdites fibres.

4. Procédé pour produire de l'alumine formant des trichites selon la revendication 1, 2 ou 3, dans lequel une proportion de composant d'aluminium par composant de bore est de 9:2,5 à 1:1 1 en termes de rapport molaire.

5. Procédé pour produire de l'alumine formant des trichites selon la revendication 2 ou 3, dans lequel la fraction en volume de trichites dans l'élément compact est de 60 à 70%.

6. Procédé pour produire de l'alumine formant des trichites selon la revendication 2 ou 3, dans lequel l'oxyde de bore est préchauffé à une température d'au moins 180°C au moment où on le mélange ou on le fournit.

7. Fibres d'alumine ayant des trichites qui sont formées de manière dendritique sur la surface desdites fibres.

8. Piston composite comprenant des fibres d'alumine selon la revendication 7, lesdites fibres étant composées d'un matériau matriciel au moins dans une portion résistante à l'usure d'un porte-couronnes.
